# EUROPEAN PATENT APPLICATION

(11) **EP 2 157 702 A2**
(43) Date of publication of application: **24.02.2010**
(21) Application number: 09010013.2
(22) Date of filing: 03.08.2009
(51) Int. Cl.: H04B 1/10

(54) **Method and system for processing signals in a wireless system**

(30) Priority: 19.08.2008 US 90037 P; 01.12.2008 US 325715
(71) Applicant: Broadcom Corporation, Irvine, CA 92617 (US)
(72) Inventor: Georgantas, Theodore, 12461 Chaidari (GR); Haralabidis, Nikolaos, 11635 Athens (GR); Kavadias, Spyridon, 16673 Voula (GR); Bouras, Stamatios Alexandros, 16342 Ilioupolis (GR); Kapnistis, Charalampos, 15121 Pefki. (GR); Vavelidis, Konstantinos, 16342 Ilioupolis (GR); Bouras, Ilias, 16342 Ilioupolis (GR)
(74) Representative: Jehle, Volker Armin

(57) **Abstract**

Methods and systems for a variable system on demand are disclosed. Aspects of the method may include configuring one or more filters in a wireless transmitter and/or receiver for a desired band and standard. The presence of a blocker signal in a receiver may be known and/or determined and the receiver may be configured for mitigating the blocker signal. A desired received signal strength indicator may be compared to a wideband received signal strength indicator. Gain levels may be configured in the receiver based on the comparison. Linearity of the receiver may be configured for blocker signal mitigation. The filters may include baseband filters and/or may be at an output of the receiver. The filters may include a plurality of stages, with one or more of the stages bypassed for filter configuring, and may include a mixer as an input. Capacitors and/or resistors may be configured in the filters.

## Description

### CROSS-REFERENCE TO RELATED APPLICATIONS/INCORPORATION BY REFERENCE

This application makes reference to and claims priority to United States Provisional Application Serial No. 61/090,037 filed on August 19, 2008.

This application also makes reference to:
United States Patent Application Serial No. (Attorney Docket No. 19549US02) filed on even date herewith;
United States Patent Application Serial No. (Attorney Docket No. 19551US02) filed on ; and
United States Patent Application Serial No. (Attorney Docket No. 19550US01) filed on even date herewith.

Each of the above stated applications is hereby incorporated herein by reference in its entirety.

### FEDERALLY SPONSORED RESEARCH OR DEVELOPMENT

[Not Applicable]

### [MICROFICHE/COPYRIGHT REFERENCE]

### [Not Applicable]

### FIELD OF THE INVENTION

Certain embodiments of the invention relate to wireless communication. More specifically, certain embodiments of the invention relate to a method and system for a variable system on demand.

### BACKGROUND OF THE INVENTION

Mobile communications have changed the way people communicate and mobile phones have been transformed from a luxury item to an essential part of every day life. The use of mobile phones today is dictated by social situations, rather than hampered by location or technology. While voice connections fulfill the basic need to communicate, and mobile voice connections continue to filter even further into the fabric of every day life, various integrated mobile multimedia applications, utilizing the mobile Internet, may be the next step in the mobile communication revolution.

Third generation (3G) cellular networks offering various high speed access technologies and mobile telephones that have been specifically designed to utilize these technologies, fulfill demands for integrated multimedia applications supporting TV and audio applications utilizing advanced compression standards, high-resolution gaming applications, musical interfaces, and peripheral interface support. The processing requirements are being increased as chip designers take advantage of compression and higher bandwidths to transmit more information. 3G wireless applications support bit rates from 384 kilobits (Kbits)/second to 2 megabits (Mbits)/second, allowing chip designers to provide wireless systems with multimedia capabilities, superior quality, reduced interference, and a wider coverage area.

As mobile multimedia services grow in popularity and usage, factors such as power consumption, cost efficient optimization of network capacity and quality of service (QoS) will become even more essential to cellular operators than it is today. These factors may be achieved with careful network planning and operation, improvements in transmission methods, and advances in receiver techniques and chip integration solutions. To this end, carriers need technologies that will allow them to increase downlink throughput for the mobile multimedia applications support and, in turn, offer advanced QoS capabilities and speeds for consumers of mobile multimedia application services.

Further limitations and disadvantages of conventional and traditional approaches will become apparent to one of skill in the art, through comparison of such systems with the present invention as set forth in the remainder of the present application with reference to the drawings.

### BRIEF SUMMARY OF THE INVENTION

A system and/or method for a variable system on demand, substantially as shown in and/or described in connection with at least one of the figures, as set forth more completely in the claims.
According to an aspect, a method for processing signals comprises:
in a multi-band, multi-standard wireless transmitter and/or wireless receiver:
   configuring one or more filters in said wireless transmitter and/or wireless receiver for operation in a desired band and desired communication standard;
   determining presence of a blocker signal received by said wireless receiver for said operation; and
   configuring said wireless receiver to mitigate said blocker signal.
Advantageously, the method further comprises comparing a wideband received signal strength indicator associated with a signal received by said wireless receiver to a desired received signal strength indicator.
Advantageously, the method further comprises configuring one or more gain levels in said wireless receiver based on said comparing.
Advantageously, the method further comprises predicting one more blocker signals based on a location of said wireless transmitter and/or wireless receiver prior to said operation.
Advantageously, the method further comprises configuring a linearity of said wireless receiver to mitigate said blocker signal.
Advantageously, said one or more filters comprise baseband filters.
Advantageously, said one or more filters are at an output of said wireless receiver.
Advantageously, said one or more filters comprise a plurality of stages.
Advantageously, the method further comprises bypassing one or more of said plurality of stages for said configuring of said one or more filters.
Advantageously, the method further comprises configuring one or more capacitors in said one or more filters.
Advantageously, the method further comprises configuring one or more resistors in said one or more filters.
Advantageously, the method further comprises receiving a signal at an input of said one or more filters utilizing a mixer.
According to an aspect, a system for processing signals comprises:
   one or more circuits in a multi-band, multi-standard wireless transmitter and/or wireless receiver, wherein said one or more circuits are enabled to configure one or more filters in said wireless transmitter and/or wireless receiver for operation in a desired band and desired communication standard, wherein:
      said one or more circuits are enabled to determine presence of a blocker signal received by said wireless receiver for said operation; and
      said one or more circuits are enabled to configure said wireless receiver to mitigate said blocker signal.
Advantageously, said one or more circuits are enabled to compare a wideband received signal strength indicator associated with a signal received by said wireless receiver to a desired received signal strength indicator.
Advantageously, said one or more circuits are enabled to configure one or more gain levels in said wireless receiver based on said comparing.
Advantageously, said one or more circuits are enabled to predict one more blocker signals based on a location of said wireless transmitter and/or wireless receiver prior to said operation.
Advantageously, said one or more circuits are enabled to configure a linearity of said wireless receiver to mitigate said blocker signal.
Advantageously, said one or more filters comprise baseband filters.
Advantageously, said one or more filters are at an output of said wireless receiver.
Advantageously, said one or more filters comprise a plurality of stages.
Advantageously, said one or more filters are enabled to bypass one or more of said plurality of stages for said configuring of said one or more filters.
Advantageously, said one or more circuits are enabled to configure one or more capacitors in said one or more filters.
Advantageously, said one or more circuits are enabled to configure one or more resistors in said one or more filters.
Advantageously, said one or more circuits are enabled to receive a signal at an input of said one or more filters utilizing a mixer.

Various advantages, aspects and novel features of the present invention, as well as details of an illustrated embodiment thereof, will be more fully understood from the following description and drawings.

### BRIEF DESCRIPTION OF SEVERAL VIEWS OF THE DRAWINGS

FIG. 1 is a block diagram of an exemplary mobile terminal that may utilize a variable system on demand, in accordance with an embodiment of the invention.

FIG. 2 is a block diagram illustrating an exemplary long term evolution (LTE) radio for providing a variable system on demand, in accordance with an embodiment of the invention.

FIG. 3 is a block diagram illustrating an exemplary baseband filter, in accordance with an embodiment of the invention.

FIG. 4 is a block diagram illustrating an exemplary transmit architecture that may enable a variable system on demand, in accordance with an embodiment of the invention.

FIG. 5 is a block diagram illustrating an exemplary receive architecture, in accordance with an embodiment of the invention.

FIG. 6 is a block diagram illustrating wideband received signal strength indication, in accordance with an embodiment of the invention.

FIG. 7 is a flow diagram illustrating exemplary steps enabling a variable system on demand, in accordance with an embodiment of the invention.

### DETAILED DESCRIPTION OF THE INVENTION

Certain embodiments of the invention may be found in a method and system for a variable system on demand. Exemplary aspects of the invention may comprise configuring one or more filters in a transmitter, a receiver, and/or a transceiver for a desired band and/or communication standard. The presence of a blocker signal in a receiver in the transceiver may be determined and the receiver may be configured for mitigating the blocker signal. A desired received signal strength indicator may be compared to a wideband received signal strength indicator in order to mitigate the blocker signal. Blocker signals may be predicted based on a location of the wireless transmitter and/or wireless receiver prior to the operation. One or more gain levels may be configured in the receiver based on the comparison. A linearity of the receiver may be configured in order to mitigate the blocker signal, and may comprise baseband filters. The one or more filters may comprise baseband filters, and may be at an output of the receiver. The one or more filters may comprise a plurality of stages, with one or more of the plurality of stages bypassed to enable configuration of the filters. The one or more filters may comprise a mixer as an input. One or more capacitors and/or one or more resistors may be configured in the one or more filters.

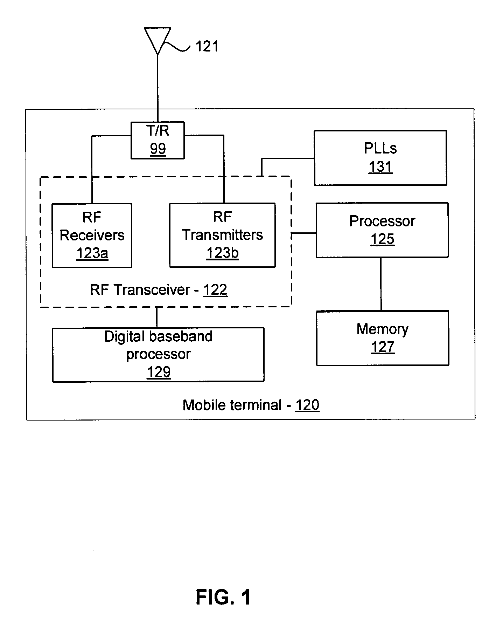

FIG. 1 is a block diagram of an exemplary mobile terminal that may utilize a variable system on demand, in accordance with an embodiment of the invention. Referring to FIG. 1, there is shown a wireless terminal 120 that may comprise an RF receiver 123a, an RF transmitter 123b, a digital baseband processor 129, PLLs 131, a processor 125, and a memory 127. The wireless terminal 120 may enable communication via a cellular network (GSM/EDGE, WCDMA and/or LTE), a wireless local area network (WLAN) and a Bluetooth network, and may be enabled to receive and process GPS signals. In an embodiment of the invention, the RF receiver 123a and the RF transmitter 123b may be integrated into a single RF transceiver 122, for example. The RF receiver 123a and the RF transmitter 123b may be integrated into a single chip that comprises a cellular radio (GSM/EDGE, WCDMA and/or LTE), WLAN radio and a Bluetooth radio, for example. The single chip comprising cellular, WLAN and Bluetooth radios may be implemented utilizing a single CMOS substrate, for example.

One or more transmit and receive antennas, shown schematically by the antenna 121, may be communicatively coupled to the RF receiver 123a and the RF transmitter 123b. In this regard, the antenna 121 may enable WLAN and Bluetooth transmission and/or reception, for example. A switch or other device having switching capabilities may be coupled between the RF receiver 123a and RF transmitter 123b, and may be utilized to switch the antenna 121 between transmit and receive functions in instances where a single antenna may be used to transmit and receive. The wireless terminal 120 may be operated in a system, such as a Wireless Local Area Network (WLAN), a cellular network, such as Long Term evolution (LTE), W-CDMA, and/or GSM, a digital video broadcast network, and/or a Wireless Personal Area Network (WPAN) such as a Bluetooth network, for example. In this regard, the wireless terminal 120 may support a plurality of wireless communication protocols, including the IEEE 802.11g/n standard specifications for WLAN networks.

The RF receiver 123a may comprise suitable logic, circuitry, and/or code that may enable processing of received RF signals. The RF receiver 123a may enable receiving RF signals in a plurality of frequency bands in accordance with the wireless communications protocols that may be supported by the wireless terminal 120. Each frequency band supported by the RF receiver 123a may have a corresponding front-end circuit for handling low noise amplification and down conversion operations, for example. In this regard, the RF receiver 123a may be referred to as a multi-band receiver when it supports more than one frequency band. In another embodiment of the invention, the wireless terminal 120 may comprise more than one RF receiver 123a, wherein each of the RF receiver 123a may be a single-band or a multi-band receiver. The RF receiver 123a may be implemented on a chip. In an embodiment of the invention, the RF receiver 123a may be integrated with the RF transmitter 123b on a chip to comprise an RF transceiver, for example. In another embodiment of the invention, the RF receiver 123a may be integrated on a chip with more than one component in the wireless terminal 120.

The RF receiver 123a may quadrature down convert the received RF signal to a baseband frequency signal that comprises an in-phase (I) component and a quadrature (Q) component. The RF receiver 123a may perform direct down conversion of the received RF signal to a baseband frequency signal, for example. In some instances, the RF receiver 123a may enable analog-to-digital conversion of the baseband signal components before transferring the components to the digital baseband processor 129. In other instances, the RF receiver 123a may transfer the baseband signal components in analog form.

The digital baseband processor 129 may comprise suitable logic, circuitry, and/or code that may enable processing and/or handling of baseband frequency signals. In this regard, the digital baseband processor 129 may process or handle signals received from the RF receiver 123a and/or signals to be transferred to the RF transmitter 123b, when the RF transmitter 123b is present, for transmission to the network. The digital baseband processor 129 may also provide control and/or feedback information to the RF receiver 123a and to the RF transmitter 123b based on information from the processed signals. The digital baseband processor 129 may communicate information and/or data from the processed signals to the processor 125 and/or to the memory 127. Moreover, the digital baseband processor 129 may receive information from the processor 125 and/or to the memory 127, which may be processed and transferred to the RF transmitter 123b for transmission to the network. In an embodiment of the invention, the digital baseband processor 129 may be integrated on a chip with more than one component in the wireless terminal 120.

The RF transmitter 123b may comprise suitable logic, circuitry, and/or code that may enable processing of RF signals for transmission. The RF transmitter 123b may enable transmission of RF signals in a plurality of frequency bands. Each frequency band supported by the RF transmitter 123b may have a corresponding front-end circuit for handling amplification and up conversion operations, for example. In this regard, the RF transmitter 123b may be referred to as a multi-band transmitter when it supports more than one frequency band. In another embodiment of the invention, the wireless terminal 120 may comprise more than one RF transmitter 123b, wherein each of the RF transmitter 123b may be a single-band or a multi-band transmitter. The RF transmitter 123b may be implemented on a chip. In an embodiment of the invention, the RF transmitter 123b may be integrated with the RF receiver 123a on a chip to comprise an RF transceiver, for example. In another embodiment of the invention, the RF transmitter 123b may be integrated on a chip with more than one component in the wireless terminal 120.

The RF transmitter 123b may quadrature up convert the baseband frequency signal comprising I/Q components to an RF signal. The RF transmitter 123b may perform direct up conversion of the baseband frequency signal to a baseband frequency signal, for example. In some instances, the RF transmitter 123b may enable digital-to-analog conversion of the baseband signal components received from the digital baseband processor 129 before up conversion. In other instances, the RF transmitter 123b may receive baseband signal components in analog form.

The processor 125 may comprise suitable logic, circuitry, and/or code that may enable control and/or data processing operations for the wireless terminal 120. The processor 125 may be utilized to control at least a portion of the RF receiver 123a, the RF transmitter 123b, the digital baseband processor 129, and/or the memory 127. In this regard, the processor 125 may generate at least one signal for controlling operations within the wireless terminal 120. The processor 125 may also enable executing of applications that may be utilized by the wireless terminal 120. For example, the processor 125 may generate at least one control signal and/or may execute applications that may enable current and proposed WLAN communications and/or Bluetooth communications in the wireless terminal 120.

The memory 127 may comprise suitable logic, circuitry, and/or code that may enable storage of data and/or other information utilized by the wireless terminal 120. For example, the memory 127 may be utilized for storing processed data generated by the digital baseband processor 129 and/or the processor 125. The memory 127 may also be utilized to store information, such as configuration information, that may be utilized to control the operation of at least one block in the wireless terminal 120. For example, the memory 127 may comprise information necessary to configure the RF receiver 123a for receiving WLAN and/or Bluetooth signals in the appropriate frequency band.

The RF receiver 123a may comprise a low noise amplifier (LNA) that may be configurable for single-ended or differential mode. Similarly an on-chip balun may also be configurable for single-ended or differential mode. In this manner, the balun may be integrated on-chip as a load to the LNA, thereby improving the noise figure for the RF receiver 123a.

Aspects of the invention may enable supporting a plurality of wireless standards in a single integrated transceiver. In this regard, each of a transmit chain and a receive chain may be configurable to support Long Term evolution (LTE), W-CDMA, and GSM wireless standards. LTE technology capabilities may comprise orthogonal frequency division multiplexing (OFDM), multiple antenna (MIMO), bandwidth scalability, existing (I-XI) and new (XII-XIV) bands, FDD and TDD, for example. OFDM capability may provide robustness against multipath issues, ease of scheduling of time/frequency resources, and increased spectral efficiency.

MIMO technology may provide enhanced data rate and performance, and may comprise 1 Tx and 2 Rx antennas, for example. Bandwidth scalability may enable efficient operation in differently-size allocated spectrum bands which may comprise 1.4, 3, 5, 10, 15 and 20 MHz, for example.

Single carrier FDMA (SC-FDMA) may enable frequency domain generation (DFT-Spread OFDM) and scalable bandwidth and flexible scheduling. In an embodiment of the invention, SC-FDMA may utilize quantized phase shift keying (QPSK) and N-bit quantized amplitude modulation (N-QAM), for example.

Configurable components/portions of the RF receivers 123a may comprise LNA(s), mixer(s), RF filter(s), PLL(s), VCO(s), ADC(s), and baseband filter(s). The receive chain may be configured to optimize power consumption for a given standards (LTE, W-CDMA, GSM) and conditions (e.g. interference, signal strength).

Configurable components/portions of the RF transmitters 123b may comprise PA(s), mixer(s), RF filter(s), PLL(s), VCO(s), DAC(s), and baseband filter(s). The transmit chain may be configured to optimize power consumption for a given standard (LTE, W-CDMA, GSM) and condition (e.g. interference, signal strength). An exemplary way in which the transmit chain may be configured is to select between IQ modulation or polar modulation, for optimum signal strength or power usage, for example.

Since each supported communication standard may comprise different filtering requirements, the baseband filter or filters may be configured to enable communication by any of the supported standards. For example, for GSM a Butterworth filter may be utilized, for W-CDMA, a Chebyschev filter of 0.3dB ripple may be utilized, and in LTE, a Chebyschev filter with 1dB ripple may be utilized. Furthermore, the filter bandwidth requirements may be different. For GSM the bandwidth may be up to 300 kHz, in wideband CDMA up to 2 MHz, and in LTE the bandwidth may vary from 0.7 MHz to 10 MHz. Thus, there may be a plurality of different filter types and a plurality of different filter cutoff frequencies in the filter. In an exemplary embodiment of the invention, there may be three different filter types and eight different filter cutoff frequencies in the filter.

In accordance with various embodiments of the invention, various portions of the filter may be activated for the different wireless standards. For example, all stages of the filter may be activated for LTE, while only two of three stages, for example, may be activated for GSM. The filters may be tuned via switched capacitors or resistors, for example. The power consumption of the mobile terminal 120 may be configured depending on the standard being utilized by scaling the current of the RF receivers 123a or bypassing unneeded stages of the filters.

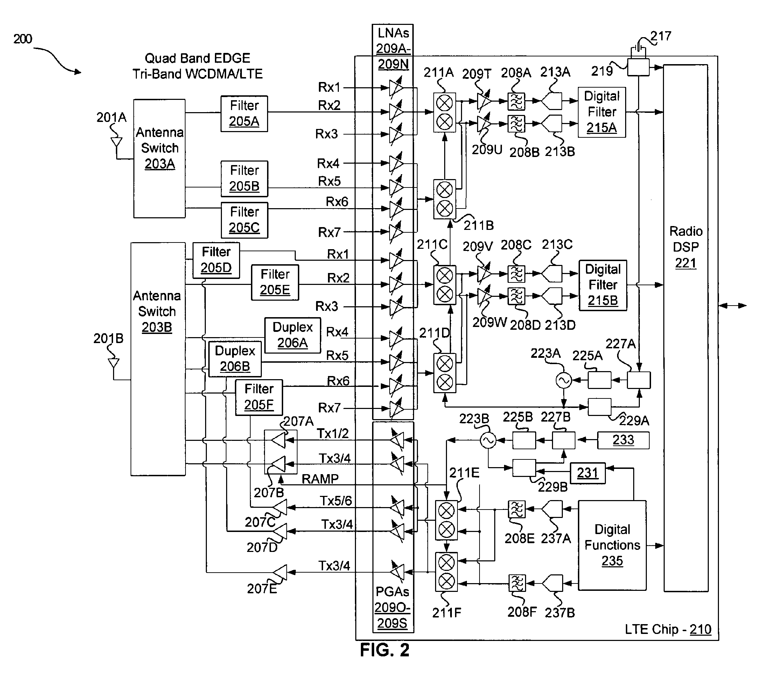

FIG. 2 is a block diagram illustrating an exemplary long term evolution (LTE) radio for providing a variable system on demand, in accordance with an embodiment of the invention. Referring to FIG. 2, there is shown an LTE radio platform 200 comprising an LTE chip 210, antennas 201A and 201B, antenna switches 203A and 203B, filters 205A-205H, duplexers 206A-206B, amplifiers 207A-207E, and a crystal oscillator 217.

The LTE chip 210 may comprise low noise amplifiers (LNAs) 209A-209N, RF PGAs 2090-209S, mixers 211A-211F, filters 208A-208F, analog to digital converters (ADCs) 213A-213D, digital filters 215A and 215B, a crystal oscillator control block 219, a radio DSP 221, voltage controlled oscillators (VCOs) 223A and 223B, low pass filters 225A and 225B, phase-frequency detector (PFD)/charge pump (CP) blocks 227A and 227B, multi-modulus dividers (MMDs) 229A and 229B, a phase modulator 231, a reference PLL 233, a digital functions block 235, and digital to analog converters (DACs) 237A and 237B.

The antennas 201A and 201B may comprise electromagnetic signal transmit and/or receive capability, and may be enabled to transmit or receive RF signals that may be processed by the LTE chip 210. The antenna switches 203A and 203B may comprise suitable circuitry, logic, and/or code that may enable the selection of a path to be transmitted from the LTE chip 210 and/or to communicate a received signal to the LTE chip 210.

The filters 205A-205F and the baseband filters 208A-208F may comprise suitable circuitry, logic, and/or code that may enable filtering a received signal. In this manner, a signal of a desired frequency may be communicated through the filters 205A-205F and the baseband filters 208A-208F, while signals outside the desired frequency range may be attenuated. The baseband filters 208A-208F may be configurable, comprising stages that may be switched on and off, and may also be frequency-configurable, thus enabling multiband, multi-standard operation.

The duplexers 206A and 206B may comprise suitable circuitry, logic, and/or code that may enable simultaneous operation of Tx and Rx through a single path. The duplexers 206A and 206B may filter a Tx signal to the antenna and filter Rx signals from the antenna, and may also provide isolation between a chip comprising the Tx and Rx ports in a printed circuit board, for example.

The amplifiers 207A-207E may comprise suitable circuitry, logic, and/or code that may enable the amplification of a transmitted signal to a desired amplitude suitable for transmission via the antenna 201 B. The low noise amplifiers (LNAs) 209A-208N may comprise suitable circuitry, logic, and/or code that may enable the amplification of a received signal, and may be configured to a desired gain level depending on the requirements of the standard being utilized for RF communication and desired noise figure. The RF PGAs 2090-209S may comprise suitable circuitry, logic, and/or code that may enable the amplification of a transmit signal and may provide an interface to components external to the LTE chip 210.

The mixers 211A-211F may comprise suitable circuitry, logic, and/or code that may enable up-conversion of a baseband or intermediate frequency signal to an RF frequency and/or down-conversion from an RF frequency to an intermediate or baseband frequency. The mixers 211A-211F may receive as inputs a signal to be converted and a local oscillator signal that may enable frequency conversion via the generation of sum and difference signals with the undesired signal subsequently being filtered out, leaving a signal at a desired frequency.

The ADCs 213A-213D may comprise suitable circuitry, logic, and/or code that may be enabled to receive an analog signal and generate a digital output signal. The DACs 237A and 237B may comprise suitable circuitry, logic, and/or code that may be enabled to receive a digital signal and generate an analog output signal.

The digital filters 215A and 215B may comprise suitable circuitry, logic, and/or code that may enable channel match filtering, de-rotation, and/or digital filtering of a received signal in the digital domain. In this manner, undesired signals generated by the ADCs 213A and 213B may be removed before communicating a signal to the radio DSP 221.

The crystal oscillator 217 may comprise a crystal that oscillates at a characteristic frequency determined by the material in the crystal. The crystal oscillator control block 219 may comprise suitable circuitry, logic, and/or code that may control the crystal oscillator 217. The crystal oscillator control block 219 may receive a signal at a characteristic frequency from the crystal oscillator 217, amplify the signal, and communicate the amplified feedback signal back to the crystal oscillator 217. In this manner, a stable clock signal may be generated at the characteristic frequency of the crystal oscillator 217.

The radio DSP 221 may comprise suitable circuitry, logic, and/or code that may enable the processing of digital signals via arbitrary functionality defined by user preferences and/or programming. The digital signals may comprise baseband signals, for example, and may represent information to be transmitted via the antenna 201 B and/or received by the antenna 201A.

The VCOs 223A and 223B may comprise suitable circuitry, logic, and/or code that may be enabled to generate an output signal at a desired frequency as defined by an input voltage. The frequency of oscillation may be configured by varying the input voltage.

The LPFs 225A and 225B may comprise suitable circuitry, logic, and/or code that may be enabled to filter out higher frequency signals while allowing lower frequency signals to pass. The LPFs 225A and 225B may comprise feedback loops in PLLs to enable error correction and frequency lock of the PLLs. The input signals to the PLLs may comprise the crystal oscillator 217 and the reference PLL 233, for example.

The PFD/CP blocks 227A and 227B may comprise suitable circuitry, logic, and/or code that may be enabled to generate an error signal from a reference signal and a feedback signal received from a frequency divider, such as the MMDs 229A and 229B. The error signal may be communicated to the LPFs 225A and 225B before being communicated to the VCOs 223A and 223B to adjust the frequency generated.

The MMDs 229A and 229B may comprise suitable circuitry, logic, and/or code that may be enabled to divide the frequency of a signal received from the VCOs 223A or 223B. The divided frequency signal may be communicated to the PFD/CP blocks 227A and 227B to generate an error signal for frequency locking of the VCOs 223A and 223B.

The phase modulator 231 may comprise suitable circuitry, logic, and/or code that may be enabled to modulate the phase of a signal generated from a signal received from the digital functions block 235. In this manner, the phase of the LO signal generated by the VCO 223B may be configurable.

The reference PLL 233 may comprise suitable circuitry, logic, and/or code that be enabled to generate a signal at a desired frequency. The output signal may be communicated to the PFD/CP block 227B to provide a reference LO signal for configuring the VCO 223B.

The digital functions block 235 may comprise suitable circuitry, logic, and/or code that may perform specific digital functions on digital baseband signals before communicating them to the DACs 237A and 237B or the phase modulator 231. The digital functions may comprise, channel match filtering, cordic, and calibrations, for example.

In operation, the LTE radio platform 200 may comprise support for bands I through XIV and also additional standards such as HSPA+, HSPA, UMTS, and GSM/EDGE, for example. Additionally, a WCDMA/LTE system may support up to three bands using dedicated WCDMA/LTE Tx outputs or up to five bands, with multi-mode power amplifier (PA) support, for example. Similarly, the LTE radio platform 200 may support quad-band GSM/EDGE transmit and receive, LTE/WCDMA diversity with 2Rx/1Tx path, as well as FDD and TDD operation. In the Tx, bands V, VI, and VIII, may be supported, for example, with multi-mode outputs (GSM/EDGE/WCDMA on a single output) and also separate outputs. On the Rx side, new bands such as VII, XI, XIII, and XIV, for example, may also be supported with Rx diversity utilizing a single Rx VCO. Additionally, the Rx may enable linearity on demand, Tx leakage mitigation, and no Tx or Rx interstage filters or external LNAs. Similarly, reduced supply voltage may be enabled (2.3-2.5 V, for example) to support improved battery technology.

In an embodiment of the invention, the frequencies of a plurality of wireless standard signals may be known based on the location of the LTE radio platform 200 determined via GPS data, base station ID number, and/or other location-derived information. In this manner, blocker signals may be known in a given geographic location and the LTE radio platform 200 may thus be configured to mitigate the known blocker signals via configuration of the baseband filters 205A-205F and/or via gain control in the LNAs 209A-209N.

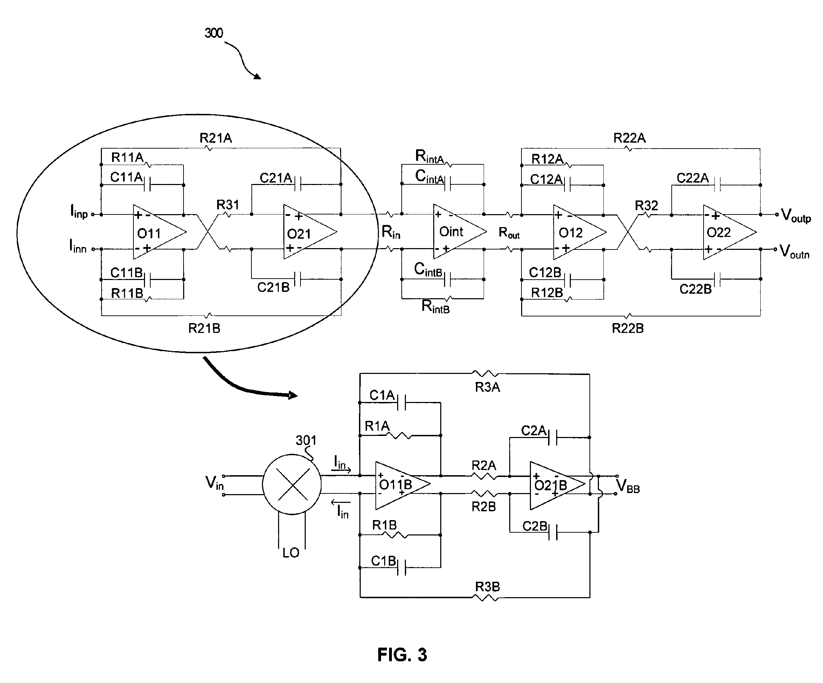

FIG. 3 is a block diagram illustrating an exemplary baseband filter, in accordance with an embodiment of the invention. Referring to FIG. 3, there is shown a baseband (BB) filter 300 comprising amplifiers O11, O21, Oint, O12, and O22, resistors R11A, R21A, R31, R11B, Rin, RintA, RintB, R12A, R22A, R32, R12B, and R22B, and capacitors C11A, C21A, C11B, C21B, CintA, CintB, C12A, C12B, C22A, and C22B.

The first stage of the BB filter 300 is shown in an alternative embodiment of the invention below the BB filter 300, comprising amplifiers O11B and O21B, resistors R1A, R1B, R3A, R2A, R2B, and R3B, and capacitors C1A, C1B, C2A, and C2B. There is also shown a mixer 301 which may receive as inputs an input voltage Vin and an LO signal. The mixer may essentially substitute a resistor that may be used as a voltage to current converter at the filter input. In this manner, the mixer operation may be incorporated into the filter providing better out-of-band rejection to Rx blockers appearing at the mixer output.

The BB filter 300 may comprise analog filters to limit the received signal or signals in the ADC dynamic range and suppress unwanted signals such as blockers or LTE interferers, for example. The BB filter 300 may comprise a reconfigurable 5^{th} order filter, such as a biquad-pole-biquad, for example, as shown in FIG. 3. In an embodiment of the invention, the resistors R11A, R21A, R31, R11B, Rin, RintA, RintB, R12A, R22A, R32, R12B, and R22B, and capacitors C11A, C21A, C11B, C21B, CintA, CintB, C12A, C12B, C22A, and C22B may be switchable impedances such that the resistance or capacitance values may be adjusted, via switching CMOS transistors, for example, thereby configuring the filter characteristics. Exemplary characteristics of the filters that may be configured comprise, cutoff frequency, ripple, and steepness of the rolloff, for example.

The amplifiers O11, O21, Oint, O12, and O22 may comprise suitable circuitry, logic, and/or code that may be enabled to provide gain for an input signal, which when coupled with the feedback provided by the resistors and capacitors, configures a multi-pole Chebyshev or Butterworth filter, for example. In an embodiment of the invention, each stage may be switched in or out of the BB filter 300 to match filter response requirements of the wireless standard being utilized, such as passband ripple, cutoff frequency, and frequency roll off, for example. Filter sections may be bypassed to reduce power use, for example. Similarly, higher filter cutoff frequency may require higher amplifier bandwidth, which may result in higher power consumption. Thus, amplifier power consumption may be programmable by utilizing lower cutoff frequencies.

The number of stages of the BB filter 300 is not limited to the number shown in FIG. 3. Accordingly, any number of stages may be incorporated depending on the system filter requirements.

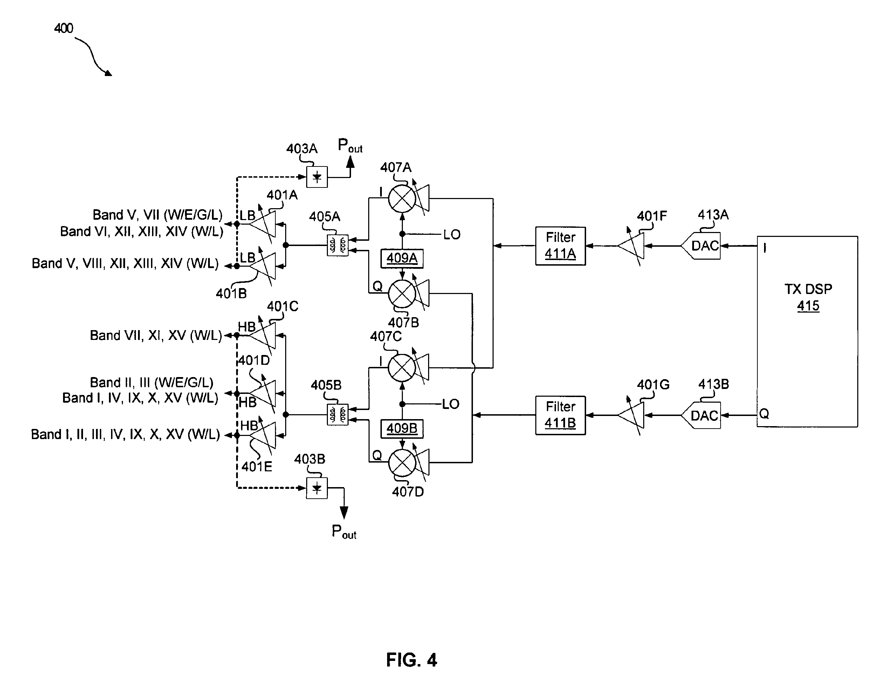

FIG. 4 is a block diagram illustrating an exemplary transmit architecture that may enable a variable system on demand, in accordance with an embodiment of the invention. Referring to FIG. 4, there is shown a multi-standard Tx 400 comprising baseband PGAs 401A-401G, envelope detectors 403A and 403B, baluns 405A and 405B, mixer/PGAs 407A-407D, 90 degree phase blocks 409A and 409B, filters 411A and 411 B, DACs 413A and 413B, and a Tx DSP 415.

The baseband PGAs 401G-401F, the RF PGAs 401A-401E, and the DACs 413A and 413B may be substantially similar to the amplifiers 207A-207E, the RF PGAs 209P-209S, and the DACs 237A and 237B described with respect to FIG. 2.

The envelope detectors 403A and 403B may comprise diodes, for example, that may enable the detection of the envelope function of the amplified signals at the outputs of the RF PGAs 401A-401 E. In this manner, the output power of the multi-standard Tx 400 may be determined, thereby enabling the control of output power via feedback to RF PGAs.

The baluns 405A and 405B may comprise transformers that may be enabled to transform a balanced signal to an unbalanced signal for transmission via an antenna, for example.

The mixer/PGAs 407A-407D may comprise suitable circuitry, logic, and/or code that may enable to up-convert a baseband or IF signal to an RF signal and apply a configurable gain. The mixer/PGAs 407A-407D may receive as inputs an LO signal and a baseband/IF signal to be upconverted.

The mixer/PGAs 407A-407D may comprise IQ upconverters for WCDMA/LTE, IQ/Polar for EDGE and direct (PLL) modulation for GSM. The architecture may comprise multi-mode outputs, such as WCDMA/LTE and GSM/EDGE, for example, at the same outputs, which may enable flexible front-end configuration via multi-standard PAs, legacy PAs, and polar PAs for EDGE.

The 90 degree phase blocks may comprise suitable circuitry, logic, and/or code that may be enabled to provide a phase shift, 90 degrees for example, to a received signal. In this manner, I and Q mixers may receive LO signals from the same source, with one being shifted by 90 degrees.

The filters 411A and 411B may comprise lowpass filters, for reconstruction and smoothing, for example, and may be enabled to filter signals with frequencies outside of a desired band and to allow signals with frequencies within the desired band. The filters 411A and 411B may be configurable filters with a plurality of stages, each of which may be activated or deactivated depending on the type and operational characteristics of filter desired. For example, a 5th order Chebyshev filter with 1 dB ripple may be utilized for LTE, whereas a 3rd order Butterworth filter may be utilized for GSM/EDGE. In this manner, multiple wireless standards may be transmitted by the same Tx path. Similarly, higher filter cutoff frequency may require higher amplifier bandwidth, which may result in higher power consumption. Thus, amplifier power consumption may be programmable by utilizing lower cutoff frequencies.

The Tx DSP 415 may comprise suitable circuitry, logic, and/or code that may enable the processing of digital signals via arbitrary functionality defined by user preferences and/or programming. The digital signals may comprise baseband signals, for example, and may represent information to be transmitted via an antenna via the multi-standard Tx 400.

In operation, baseband signals may be processed by the Tx DSP 415 which may generate I and Q signals to be communicated to the DACs 413A and 413B, respectively. The DACs 413A and 413B may convert the received signals to analog signals before communicating them to the baseband PGAs 401F and 401G, which may apply gain to the received signals.

The amplified signals may then be communicated to the filters 411A and 411B where unwanted signals may be filtered out before the desired signals may be communicated to the mixer/PGAs 407A-407D. The filtered signals may then be upconverted to RF signals via the LO signals received by the mixer/PGAs 407A-407D. Each of the mixer/PGAs 407A-407D may upconvert an I or Q signal with an I and a Q signal being communicated to each of the baluns 405A and 405B, which may convert the received signals to an unbalanced signal. The converted signals may be communicated to the RF PGAs 401A-401E. The PGAs 401A-401E may be activated to amplify the desired signal, depending on which standard and/or frequency band may be utilized.

In an embodiment of the invention, the filters 411A and 411B may be configured for the wireless standard being utilized by the multi-standard Tx 400. The order and type may be configured for a specific standard, and also may be configured to bypass one or more stages in a filter to reduce power when desired. In addition, amplifier power consumption may also be programmable to save power for lower filter cut-off frequencies.

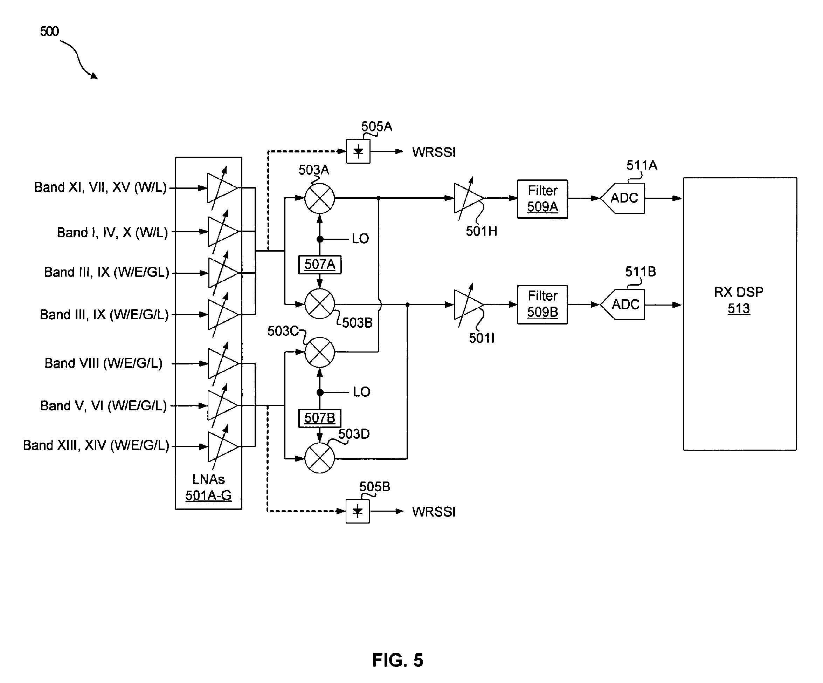

FIG. 5 is a block diagram illustrating an exemplary receive architecture, in accordance with an embodiment of the invention. Referring to FIG. 5, there is shown a multi-standard Rx 500 comprising LNAs 501A-501G, mixers 503A-503D, envelope detectors 505A and 505B, 90 degree phase blocks 507A and 507B, filters 509A and 509B, ADCs 511A and 511 B, and an Rx DSP 513.

The LNAs 501A-501G, the mixers 503A-503D, the envelope detectors 505A and 505B, the 90 degree phase blocks 507A and 507B, the filters 509A and 509B, and the ADCs 511A and 511B may be substantially similar to the LNAs 209A-209W, the envelope detectors 403A and 403B, the 90 degree phase blocks 409A and 409B, the filters 411A and 411B, and the ADCs 213A-213D described with respect to FIGS. 2 and 4.

The Rx DSP 513 may comprise suitable circuitry, logic, and/or code that may enable the processing of digital signals via arbitrary functionality defined by user preferences and/or programming. The digital signals may comprise baseband signals, for example, and may represent information received by the multi-standard Rx 500.

In operation, RF signals from one or more of a plurality of wireless standards may be received by the multi-standard Rx 500 via an antenna, such as the antenna 201A, for example, described with respect to FIG. 2. The received signals may be amplified the LNAs 501A-501G, depending on the frequency band or wireless standard of the received signal, before being down-converted by the mixers 503A-503D.

The mixers 503A-503D may down-convert the amplified signals and by utilizing the 90 degree phase blocks, may generate I and Q signals. The I and Q signals may be amplified by the PGAs 501 H and 501 before being filtered by the filters 509A and 509B. The filtered signals may then be communicated to the ADCs 511A and 511B to be converted to digital signals that may be processed by the Rx DSP 513.

The envelope detectors 505A and 505B may measure the received signal, or wideband received signal strength indicator (WRSSI), which may be utilized to control the gain of the LNAs 501A-501G, and may also be utilized to determine the presence of blocker signals. In this manner, in instances where a blocker signal is present, the gain of the appropriate LNA 501A-501G may be reduced. In addition, the linearity of the multi-standard Rx 500 may be configured by monitoring the WRSSI and adjusting the gain of the LNAs 501A-501G.

In an embodiment of the invention, the filters 509A and 509B may be configured for the wireless standard being utilized by the multi-standard Rx 500. The order and type of the filter being utilized may be configured for a specific standard, and also may be configured to bypass one or more stages in the filter to reduce power when desired. In another embodiment of the invention, the multi-standard Rx 500 current may be scaled in the absence of blocker signals to optimize the desired received signal. In addition, amplifier power consumption may also be programmable to save power for lower filter cut-off frequencies.

The multi-standard Rx 500 may comprise a low IF for EDGE/GSM and direct conversion capability for WCDMA/LTE, and may comprise reconfigurable BB filters and ADCs. The multi-standard Rx 500 may enable linearity on demand via Rx current scaling in the absence of blockers, for example.

The multi-standard Rx 500 may comprise a plurality of HB and LB LNAs comprising the LNAs 501A-501G, that may drive the plurality of HB and LB mixers, the mixers 503A-503D. The LNAs 501A-501G may comprise common-source cascode technology, for example, and may provide fine and coarse gain steps via current steering.

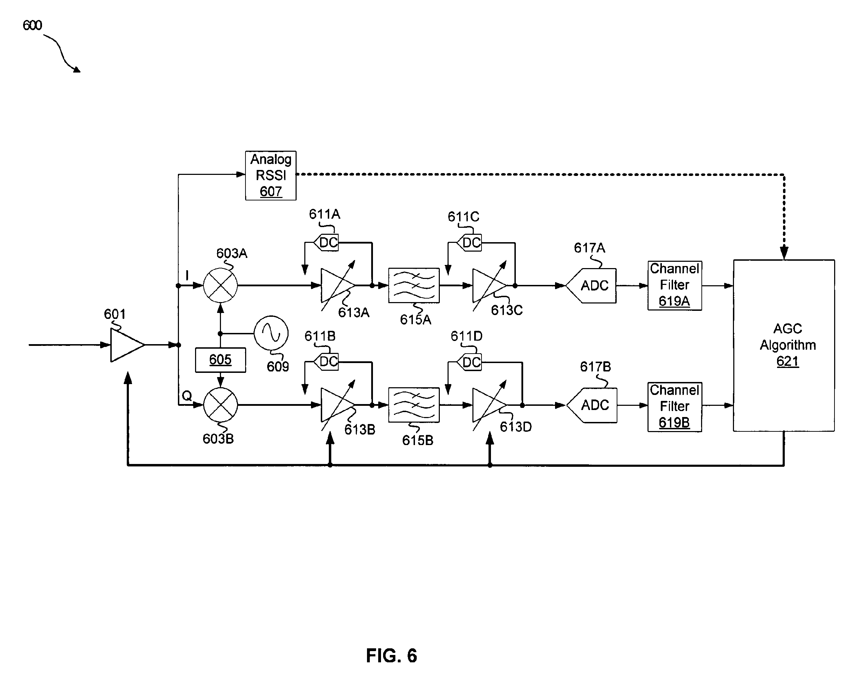

FIG. 6 is a block diagram illustrating wideband received signal strength indication, in accordance with an embodiment of the invention. Referring to FIG. 6, there is shown an Rx path 600 comprising an LNA 601, mixers 603A and 603B, a 90 degree phase block 607, an analog RSSI block 607, an LO 609, DC servos 611A-611D, LNAs 613A-613D, filters 615A and 615B, ADCs 617A and 617B, channel filters 619A and 619B, and an automatic gain control (AGC) algorithm block 621.

The LNA 601, mixers 603A and 603B, 90 degree phase block 607, analog RSSI block 607, LO 609, filters 615A and 615B, and ADCs 617A and 617B may be substantially similar to the LNAs 501A-501G, the mixers 503A-503D, the 90 degree phase blocks 507A and 507B, the envelope detectors 505A and 505B, the filters 509A and 509B, and the ADCs 511A and 511B, described with respect to FIG. 5.

The DC servos 611A-611D may comprise suitable circuitry, logic, and/or code that may be enabled to minimize DC offset in the signal to avoid saturation of the subsequent gain stages. The DC servos 611A-611 D may comprise feedback paths around the LNAs 613A-613D, and may comprise a low pass filter that determines the DC offset and subtracts it at the input of the LNAs 613A-613D.

The channel filters 619A and 619B may comprise digital filters that may be enabled to select the desired channel from the received signals in the I and Q Rx paths. The channel filters may receive input signals from the ADCs 617A and 617B and communicate output signals to the AGC algorithm block 621.

The AGC algorithm block 621 may comprise suitable circuitry, logic, and/or code that may be enabled to control the gain stages of the Rx path 600 to provide desired linearity and/or blocker signal rejection, for example.

In operation, a received signal may be amplified by the LNA 601 and down-converted by the mixers 603A and 603B utilizing the LO 609 and the 90 degree phase-shifted LO signal, generating I and Q signals. The I and Q signals may then be amplified by the PGAs 613A and 613B, filtered by the lowpass filters 615A and 615B, and amplified again by the LNAs 613C and 613D. The amplified and filtered signals may then be converted to digital signals by the ADCs 617A and 617B, and then filtered by the channel filters 619A and 619B. In this manner, a wanted signal (WS) AGC indication may be determined by the AGC algorithm block 621 that may provide an RSSI value for the wanted signal.

Additionally, the analog RSSI block 607 may provide a WRSSI signal to the AGC algorithm block 621, which may enable the configuration of the gain stages for appropriate AGC strategy and also linearity on demand. The WRSSI AGC indication may provide an RSSI value for the signal at the LNA input and may include both the WS and any out-of-band, out-of-channel interferers.

In an embodiment of the invention, the frequencies of a plurality of wireless standard signals may be known based on the location of the Rx path 600 determined via GPS data, base station ID number or cell ID, and/or other location-derived information. In this manner, blocker signal frequencies and power levels may be known in a given geographic location and the Rx path 600 may thus be configured to mitigate the known blocker signals via configuration of the filters 615A and 615B and/or via gain control in the LNAs 613A-613D.

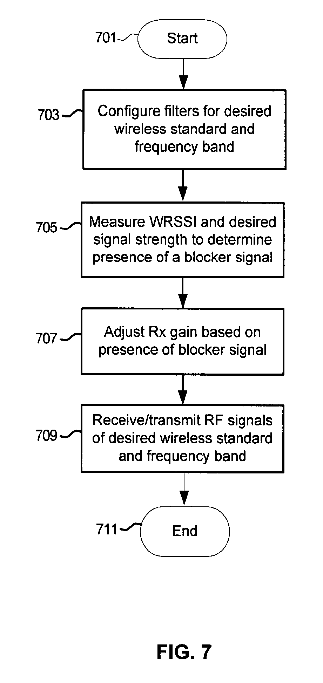

FIG. 7 is a flow diagram illustrating exemplary steps enabling a variable system on demand, in accordance with an embodiment of the invention. In step 703, after start step 701, filters 205A-205F, 208A-208F, 300, 509A/509B, and/or 615A/615B may be configured for desired frequency bands and wireless standards, followed by step 705 where a wideband received signal strength indicator and a desired signal strength may be measured. In another embodiment of the invention, the filters 205A-205F, 208A-208F, 300, 509A/509B, and/or 615A/615B may be adjusted based on known blockers as determined by the location of the wireless receiver 500/600. In step 707, the comparison of the measured signal strengths may be utilized to adjust the Rx path 600 gain, followed by step 709 where RF signals may be transmitted and/or received in a desired frequency band and utilizing a desired wireless standard.

In an embodiment of the invention, a method and system is described for a variable system on demand. In various aspects of the invention, one or more filters 205A-205F, 208A-208F in a Tx path 400 or Rx path 600 may be configured to enable operation in one or more frequency bands and/or one or more communication standards. The presence of a blocker signal in an RX path 600 in may be determined and the Rx path 600 may be configured to mitigate the blocker signal. One or more blocker signals may be predicted based on a location of the wireless transmitter and/or wireless receiver prior to receiving signals. A desired received signal strength indicator may be compared to a wideband received signal strength indicator for the reduction of the blocker signal. One or more gain levels may be configured in the RX path 600 based on the comparison. A linearity of the RX path 600 may be configured for the reduction of the blocker signal. The one or more filters 205A-205N may comprise baseband filters. The one or more filters 205A-205N may be at an output of the RX path 600. The one or more filters 205A-205N may comprise a plurality of stages, with one or more of the plurality of stages bypassed to enable configuration of one or more of the filters. The one or more filters may comprise a mixer as an input. One or more capacitors C11A, C21A, C11B, C21B, CintA, CintB, C12A, C12B, C22A, and C22B and/or one or more resistors R11A, R21A, R31, R11B, Rin, RintA, RintB, R12A, R22A, R32, R12B, and R22B may be configured in the one or more filters.

Another embodiment of the invention may provide a machine and/or computer readable storage and/or medium, having stored thereon, a machine code and/or a computer program having at least one code section executable by a machine and/or a computer, thereby causing the machine and/or computer to perform the steps as described herein for a variable system on demand

Accordingly, aspects of the invention may be realized in hardware, software, firmware or a combination thereof. The invention may be realized in a centralized fashion in at least one computer system or in a distributed fashion where different elements are spread across several interconnected computer systems. Any kind of computer system or other apparatus adapted for carrying out the methods described herein is suited. A typical combination of hardware, software and firmware may be a general-purpose computer system with a computer program that, when being loaded and executed, controls the computer system such that it carries out the methods described herein.

One embodiment of the present invention may be implemented as a board level product, as a single chip, application specific integrated circuit (ASIC), or with varying levels integrated on a single chip with other portions of the system as separate components. The degree of integration of the system will primarily be determined by speed and cost considerations. Because of the sophisticated nature of modern processors, it is possible to utilize a commercially available processor, which may be implemented external to an ASIC implementation of the present system. Alternatively, if the processor is available as an ASIC core or logic block, then the commercially available processor may be implemented as part of an ASIC device with various functions implemented as firmware.

The present invention may also be embedded in a computer program product, which comprises all the features enabling the implementation of the methods described herein, and which when loaded in a computer system is able to carry out these methods. Computer program in the present context may mean, for example, any expression, in any language, code or notation, of a set of instructions intended to cause a system having an information processing capability to perform a particular function either directly or after either or both of the following: a) conversion to another language, code or notation; b) reproduction in a different material form. However, other meanings of computer program within the understanding of those skilled in the art are also contemplated by the present invention.

While the invention has been described with reference to certain embodiments, it will be understood by those skilled in the art that various changes may be made and equivalents may be substituted without departing from the scope of the present invention. In addition, many modifications may be made to adapt a particular situation or material to the teachings of the present invention without departing from its scope. Therefore, it is intended that the present invention not be limited to the particular embodiments disclosed, but that the present invention will include all embodiments falling within the scope of the appended claims.

## Claims

1. A method for processing signals, the method comprising:
in a multi-band, multi-standard wireless transmitter and/or wireless receiver:
configuring one or more filters in said wireless transmitter and/or wireless receiver for operation in a desired band and desired communication standard;
determining presence of a blocker signal received by said wireless receiver for said operation; and
configuring said wireless receiver to mitigate said blocker signal.

2. The method according to claim 1, comprising comparing a wideband received signal strength indicator associated with a signal received by said wireless receiver to a desired received signal strength indicator.

3. The method according to claim 2, comprising configuring one or more gain levels in said wireless receiver based on said comparing.

4. The method according to claim 1, comprising predicting one more blocker signals based on a location of said wireless transmitter and/or wireless receiver prior to said operation.

5. The method according to claim 1, comprising configuring a linearity of said wireless receiver to mitigate said blocker signal.

6. The method according to claim 1, wherein said one or more filters comprise baseband filters.

7. A system for processing signals, the system comprising:
one or more circuits in a multi-band, multi-standard wireless transmitter and/or wireless receiver, wherein said one or more circuits are enabled to configure one or more filters in said wireless transmitter and/or wireless receiver for operation in a desired band and desired communication standard, wherein:
said one or more circuits are enabled to determine presence of a blocker signal received by said wireless receiver for said operation; and
said one or more circuits are enabled to configure said wireless receiver to mitigate said blocker signal.

8. The system according to claim 7, wherein said one or more circuits are enabled to compare a wideband received signal strength indicator associated with a signal received by said wireless receiver to a desired received signal strength indicator.

9. The system according to claim 8, wherein said one or more circuits are enabled to configure one or more gain levels in said wireless receiver based on said comparing.

10. The system according to claim 7, wherein said one or more circuits are enabled to predict one more blocker signals based on a location of said wireless transmitter and/or wireless receiver prior to said operation.
